# EUROPEAN PATENT SPECIFICATION

(11) **EP 2 675 067 B1**
(45) Date of publication and mention of the grant of the patent: **16.10.2019**
(21) Application number: 12354035.3
(22) Date of filing: 12.06.2012
(51) Int. Cl.: H03K 19/007

(54) **Robust circuit protected against transient perturbations and timing faults**
Gegen vorübergehende Störungen und Timing-Fehler geschützte, robuste Schaltung
Circuit robuste protégé contre des perturbations transitoires et défauts de synchronisation

(43) Date of publication of application: 18.12.2013
(73) Proprietor: iRoC Technologies, 38025 Grenoble (FR)
(72) Inventor: Nicolaidis, Michel, 38120 Saint Egrève (FR); Alexandrescu, Dan, 38000 Grenoble (FR)
(74) Representative: Talbot, Alexandre

(56) References cited:
- FR-A1- 2 790 887
- US-A1- 2009 024 888
- US-A1- 2011 060 975

## Description

### Background of the invention

The invention relates to a circuit protected against timing errors and parasitic disturbances.

### State of the art

Modern integrated circuits as described for example in documents US 2011/0060975 A1 and US 2009/0024888 A1 are sensitive to transient perturbations, produced by various causes, such as for instance ionizing particles. When such perturbation is produced to a logic circuit node, it can be propagated to one or more circuit outputs and be captured by one or more sampling elements (e.g. latches or flip-flops) connected to these outputs. Modern circuits are also sensitive to timing faults such as delay faults and clock skews.

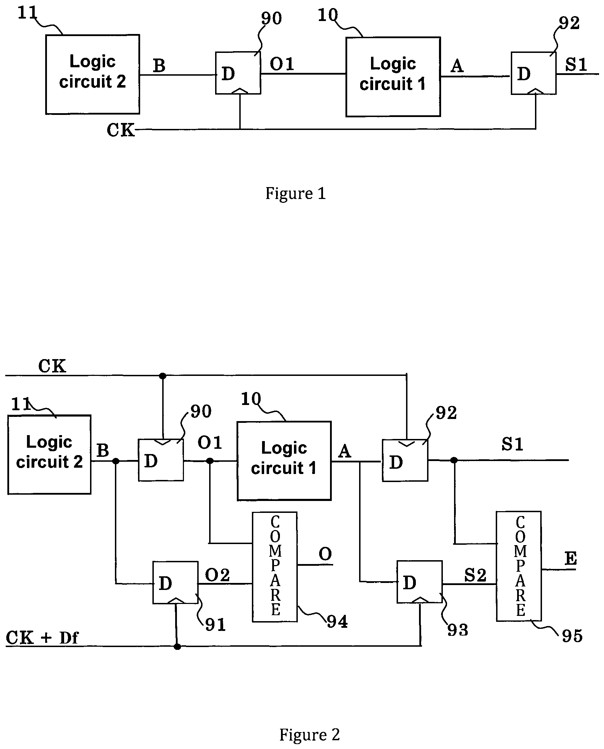

Synchronous circuits are composed of several pipe-line stages. In conventional (i.e. unprotected) designs, illustrated in figure 1, each pipe-line stage consists in a set of input sampling elements (latches or flip-flops) **90**, a combinational logic circuit (Logic circuit 1 **10**) receiving its inputs from the outputs **O1** of the input sampling elements 90, and a set of output sampling elements **92** receiving on their inputs the outputs **A** of the combinational logic circuit (Logic circuit 1 **10**), and providing outputs **S1**. Outputs **S1** may be inputs of the combinational logic circuit of a subsequent pipe-line stage. The input flip-flops **90** of a pipe-line stage are generally output flip-flops of another pipe-line stage and receive on their inputs the outputs **B** of the combinational logic of this pipe-line stage (Logic circuit 2 **11**). The input and output sampling elements of a pipe-line stage are usually sampling the signals applied on their inputs at the same event of a clock signal CK (e.g. the rising or the falling edge o the clock signal), referred hereafter as the latching event of these sampling element.

As illustrated in figure 2, previous state of the art aimed at detecting faults of a certain duration δ (Michael Nicolaidis, Circuit Logique Protégé Contre des Perturbations Transitoires, French Patent, Application Number: 2790887), substitutes each sampling element **92** of an unprotected design by a first sampling element **92** and a second sampling element **93**. Similarly to the unprotected design, input sampling element 90 and output sampling element 92 (first sampling element) of a pipe-line stage use the same event of a clock signal as latching event for sampling the signals applied on their inputs (e.g. the rising or the falling edge of a clock signal **CK**). Also, similarly to the unprotected design, first sampling element 92 provides input **S1** to the next pipe-line stage. On the other hand, second sampling element **93** is added for error detection purposes. A comparator (COMPARE) **95** receives on its inputs the outputs **S1 S2** of the first and second sampling elements **92 93**, as shown in figure 2. The clock event determining the latching event of the second sampling element **93** is delayed by a time duration Df with respect to the clock event determining the latching event of the first sampling element **92**. This enables detecting any fault of duration equal to or lower than δ, with δ ≤ Df - h₁ - s₂ (where s₂ is the setup time of the second sampling element **93** and h₁ is the hold time of the first sampling element **92**). To implement the delayed clock event determining the latching event of the second sampling element, a first embodiment of the previous state of the art rates the second sampling element **93** by using a clock signal **CK + Df**, which is delayed by delay Df with respect to the clock signal CK rating the first sampling element **92** (as illustrated in figure 2). In a second embodiment of the previous state of the art, the same clock signal CK is used to rate both the first and the second sampling elements **92 93**, but their latching events are activated by a different edge of this signal. For instance the latching event of the first sampling element **92** is activated by the rising edge of the clock signal, while the latching event of the second sampling element **93** is activated by the falling edge of the clock signal. In this case, the time interval Df separating a latching event of the first sampling element from the subsequent latching event of the second sampling element is equal to the duration of the high level of the clock signal CK rating the first and the second sampling elements. On the other hand, if the falling edge of the clock signal CK is selected as the latching event of the first sampling element **92**, and the rising edge of the clock signal CK is selected as the latching event of the second sampling element **93**, then, Df is equal to the duration of the low level of the clock signal.

As mentioned earlier, input sampling element **90** and first sampling element **92** use the same clock event as latching event. Thus, when this event occurs in cycle i of clock signal **CK** (considered for the illustration to be its rising edge) new values are latched in the input sampling elements **90** and are applied to the inputs of Logic circuit 1 **10**. At the same the first sampling element **92** latches the value present at the output **A** of Logic circuit 1 **10**, which was computed during the previous cycle (cycle i-1) of clock signal **CK**. In absence of faults, the second sampling element **93** should latch the same value as the first sampling element **92**. The latching event of the second sampling element **93** is delayed by a time Df with respect to the common latching event of first sampling element **92** and of input sampling element **90**. If Df is larger that the shortest delay of the circuit comprising the input sampling element **90**, the Logic circuit 1 **10**, and the second sampling element **93** (i.e. if Df > D_{IN} + D_{SL}- h₂, where D_{IN} is the propagation delay of input sampling element **90** D_{SL} is the shortest delay of Logic circuit 1 **10, and** h₂ is the hold time of the second sampling element **93**), then, the values captured by the input sampling element 90 at clock cycle i will have time to propagate until the second sampling element before the end of its hold time.

Thus, the second sampling element **93** may latch a value different from the one captured by the first sampling element **92** (which was computed at the previous clock cycle i-1). Thus, the comparator **95** may detect errors even in the absence of faults (false alarms). Due to this problem, designs based on the previous state of the art must have to use values for delay Df (time difference between the latching event of the first sampling element and the subsequent latching event of the second sampling element) that are shorter than a shortest circuit delay (i.e. Df < D_{IN} + D_{SL} - h₂, where D_{IN} is the propagation delay of input sampling element **90**, D_{SL} is the shortest delay of Logic circuit 1 **10**, and h₂ is the hold time of the second sampling element **93**. When a circuit is used in an environment producing large disturbances it will be useful to increase the difference between the instants at which the first and second sampling elements **92 93** latch their inputs, in order to detect faults of large duration. However, according to the previous state of the art, this time should be shorter than the shortest delays of the circuit. (Michael Nicolaidis, CIRCUIT LOGIQUE PROTEGE CONTRE DES PERTURBATIONS TRANSITOIRES, French patent, Application Number: 2790887: column 10, lines 31, 32: "In other words propagation time tc must be longer than δ.").

Thus, the previous state of the art prohibits increasing at will this time difference in order to ensure the detection of faults of large duration. This restricts the versatility of the robust design approach shown in figure 2.

### Object of the invention

The object of the invention is to provide means for protecting circuits against transient perturbations and timing faults.

The invention is defined in independent claim 1. The circuit protected against timing errors and parasitic disturbances according to the invention is characterized in that it comprises:
- a combinatory logic circuit having at least one input and one output;
- an input sampling element connected to said at least one input;
- a first sampling element connected to said at least one output and sampling this at least one output at the activation of a first latching event determined by an event of a first edge of a clock signal, the first sampling element being separated from the input sampling element by the combinatory logic circuit;
- a second sampling element connected to said at least one output and sampling this output at the activation of a second latching event, the second sampling element being separated from the input sampling element by the combinatory logic circuit;
- a circuit for analyzing the outputs of said first and said second sampling elements and providing an error detection signal, the analysis circuit setting said error detection signal at said pre-determined value if the outputs of said first and said second sampling elements are different;
wherein the second latching event is determined by an event of a second edge of said clock signal, and wherein the circuit is used in at least a first operating mode in which the duty cycle and the period, called T, of said clock signal, are adapted so a time interval, called Df, between the second edge and the first edge preceding the second edge of said clock signal is larger than a delay corresponding to an addition of a propagation delay of the input sampling element, a largest delay of the combinatory logic circuit and a setup time of the second sampling element.

### Brief description of the drawings

Other advantages and features will become more clearly apparent from the following description of particular embodiments of the invention given for non-restrictive example purposes only and represented in the appended drawings, in which:
- figure 1 represents a conventional synchronous design,
- figure 2 represents a robust synchronous circuit designed according to the prior art,
- figure 3 represents a compression network of the error detection signals,
- figure 4 represents a pipe-lined OR tree,
- figure 5 represents a compression network of the error detection signals for a second operating mode.
- figure 6 represents a compression network of the error detection signals for a first operating mode,
- figure 7 represents a compression network of the error detection signals adaptive to both operating modes.

### Description of a preferred embodiment of the invention

In this mode we use a delay Df which is larger than the largest circuit delays. More precisely, in this operation mode, the time interval Df separating the (common) latching event of the input sampling element **90** and of the first sampling element **92** from the subsequent latching event of the second sampling elements **93** is larger than the largest delay of the circuit comprised between the input sampling element **90** and the second sampling element **93**. That is, Df > D_{IN} + D_{LL} + s₂, where D_{IN} is the propagation delay of input sampling element **90**, D_{LL} is the largest delay of Logic circuit 1 **10**, and s₂ is the setup time of the second sampling element **93**. In addition, the clock period T is selected to be larger than Df. With Df > D_{IN} + D_{LL} + s₂, the value latched by the input sampling element **90** in cycle i has enough time to propagate to the output A of Logic circuit 1 **10** and fulfill the setup time s₂ of the second sampling element **93** before the occurrence of the latching event of this sampling element. Thus, the second sampling element **93** will latch the value that circuit 1 **10** generates at its output A in response to the value applied on its input at the latching event of clock cycle i of the input sampling element **90**. The same value will be latched by the first sampling element **92** at the latching edge of clock cycle i+l of this element. Thus, the values sampled by the first sampling element 92 and the second sampling element **93** will be equal and we can compare them against each other without producing false alarms. Note that in this operating mode, it is not Df but T-Df that determines the duration of detectable faults (where T is the clock period). Indeed, the comparator **95** compares the value present at the output A of Logic circuit 1 **10** at a time Df after the latching event of the first sampling element in clock cycle i (this value is latched by the second sampling element **93**) against the value present at the output A of Logic circuit 1 **10** at the latching edge of the first sampling element **92** in clock cycle i+1 (this value is latched by the first sampling element **92**). The time interval separating these instants is T - Df. Thus, any fault whose duration d does not exceed T - Df - h₂ - s₁ (where s₁ is the set-up time of the first sampling element **92** and h₂ is the hold time of the second sampling element **93**) is detected as it can not affect the values latched in both the first and second sampling elements **92 93**. Note that faults of duration larger than T - Df - h₂ - s₁ can also be detected, but not all of them. However, in many applications it is not required to guaranty detecting all faults. Detecting a significant percentage of them may suffice.

The consequence of the previous discussion is that the circuit in figure 2 can be operated in two modes:
- In a first operating mode (present invention), Df is larger that a circuit largest delay and also Df is shorter that the clock period T, i.e. D_{IN} + D_{LL} + s₂ < Df < T. This mode detects all transient disturbances and delay faults whose duration does not exceed T - Df - h₂ - s₁. Because Df is larger than the largest delay of the circuit and the clock period T is larger than Df, then, the clock period T exceeds the largest delays of the circuit by at least T-Df. Hence, T is larger than the strictly necessary time needed for accommodating the delays of the circuit. This means that we increase the duration of detectable faults by increasing T- Df. But at the same time we reduce the circuit speed. Therefore, this operating mode can be used to accommodate faults of any duration at the cost of circuit speed reduction. Another use of the first operating mode concerns the detection of increasing circuit delays or clock skews induced by circuit aging. For doing so, the circuit will be operated by using a small value for T- Df. As far as the circuit delays do not exceed Df (i.e. as far as D_{IN} + D_{LL} + s₂ < Df), the first and second sampling elements **92**, **93** will latch equal values. However, if due to aging the circuit delays exceed Df, sampling element **93** generating signal **S2** will latch an incorrect value and the comparator **95** will detect the delay increase induced by circuit aging. At this point the circuit still operates correctly, as signal **S1** (output of the first sampling element **92**) provided to the next pipeline level is correct, but the timing margins between the clock period T and the circuit delays are reduced. Hence the activation of the comparator output indicates that the clock period T has to be increased to improve timing guard-bands. Detecting reduced timing margins for predicting circuit degradation due to aging is becoming important and has been proposed by other authors (S. Mitra and M. Agarwal, "Circuit Failure Prediction to Overcome Scaled CMOS Reliability Challenges," International Test Conference, Santa Clara, CA, Oct. 2007). The scheme proposed here introduces a new implementation for monitoring timing margins, as described above.
- In a second operating mode (according to the previous state of the art), Df is shorter that a circuit shortest delay, i.e. Df < D_{IN} + D_{SL} - h₂. This mode does not require increasing the clock period. Thus, it allows operating the circuit at the highest speed. However, the duration of detectable faults is bounded by the value Df - h₁ - s₂ , which cannot exceed D_{IN} + D_{SL} - h₂ - h₁ - s₂, since in this mode we have Df < D_{IN} + D_{SL} - h₂.

It may be useful to design and produce a circuit that could be adapted to various environments, operating conditions, and application constraints, including environments and/or operating conditions inducing faults of various durations, applications requiring detection of faults of various durations for achieving various levels of reliability or for detecting increasing circuit delays induced by aging. Using the operating modes described previously enables adapting the circuit to any of these goals. A preferred realization of the present invention taking advantage of these operating modes consists in:
- Using a single clock signal CK for rating both the first and the second sampling elements **92 93**, and employing the one edge of the clock signal **CK** (referred hereafter as first edge) as latching event of the first sampling element **92**, and the other edge of the clock signal **CK** (referred hereafter as second edge) as latching event of the second sampling element **93**.
- Selectively adapting the duty cycle and the period of the clock signal to selectively implement:
   i. a first operating mode in which the first edge of clock signal **CK** precedes the second edge of clock signal **CK** by a time interval that is larger than a largest delay of the circuit, and further selecting in this mode values for the clock period T such that the interval T-Df exceeds any desirable value. This value can be selected to accommodate the duration of detectable faults, or the detectable margins between the clock period and the largest circuit delays;
   ii. a second operating mode in which the first edge of clock signal **CK** precedes the second edge of clock signal **CK** by a time interval that is shorter than a shortest delay of the circuit.

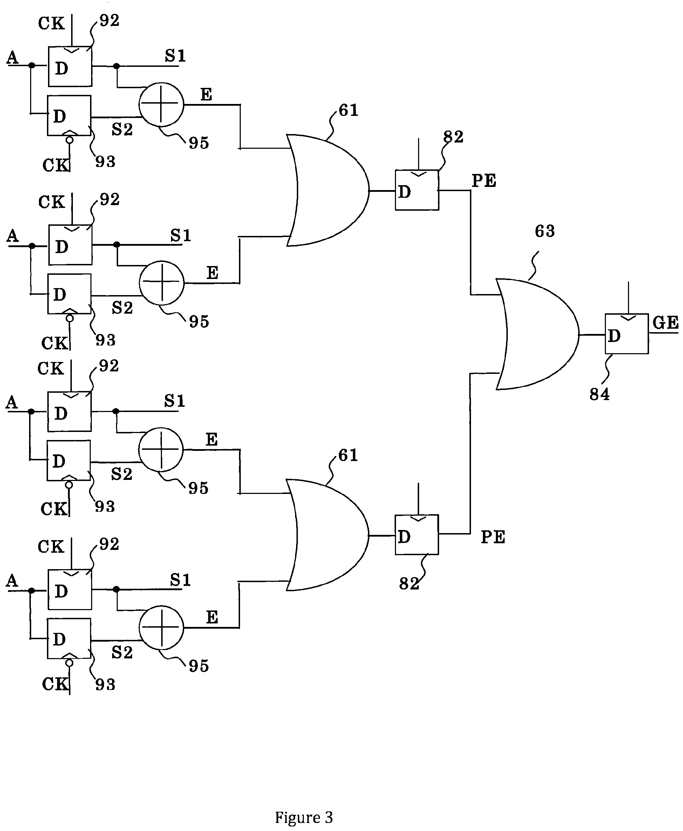

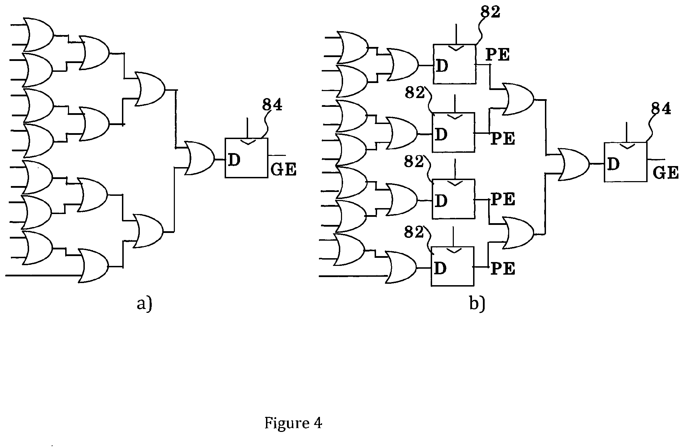

The present invention protects a sampling element **92** of an electronic circuit against timing errors and parasitic disturbances by adding a second sampling element **93** and a single-bit comparator **95** that compares their outputs. A single bit comparator consist in a XOR gate, which provides a 0 value to its output **E** when the outputs **S1** and **S2** of the first and second sampling elements **92 93** are equal, and the value 1 when outputs **S1** and **S2** are different, indicating in the later case the detection of a fault. Thus, the output **E** of the single-bit comparator (referred hereafter as error detection signal) provides an error detection indication when the outputs **S1** and **S2** of the first and second sampling elements **92 93** are different and no-error detection indication when these outputs are equal. Electronic circuits comprise numerous sampling elements. Thus, implementing the embodiment of the present invention in such circuits will result in numerous error detection signals **E**, which are difficult to monitor individually. Thus, it may be desirable to compress several error detection signals **E** into a single one, as illustrated in figure 3. In this figure several error detection signals **E** are compacted in a single error indication signal by means of an OR gate **61** (referred hereafter as OR1). The output of this gate is captured by sampling element 82 (referred hereafter as first-stage sampling elements), which provides on its output and error indication signal **PE** (referred hereafter as a partial error indication signal). If all error indication signals **E** that are inputs to an OR gate **61** (OR1) are 0 (i.e. none of them indicates error detection) the output of the OR gate **61** is also 0 and this value is captured by the first-stage sampling element **82**, which also provides on its output **PE** the value 0. Thus, the partial error indication signal **PE** also indicates the absence of errors. If one or more error indication signals **E** that are inputs to an OR gate **61** are 1 (i.e. they indicate error detection) the output of this OR gate **61** is also 1 and this value is captured by the first-stage sampling element **82**, which also provide on its output **PE** the value 1. Thus, the partial error indication signal **PE** indicates the detection of errors. Subsequently, several partial error indication signals **PE** can be compressed by an OR gate **63**, whose output is captured by a sampling element **84** (referred hereafter as subsequent sampling element stages), providing an output **GE**. This way, all error indication signals **E** in figure 3 are compressed into a global error indication signal **GE**. We could use a single OR gate and connect one sampling element on its output in order to generate the global error indication signal **GE**. However, if the number of error detection signals **E** is large, the delay of this OR gate will also be large and may require pipe-lining it in order to split it in several stages that have smaller delays. This splitting is based on the fact that a large OR gate can be implemented as a tree of smaller OR gates in which the sampling elements are inserted. As and example, figure 4a shows a 15-input OR gate implemented as a tree of smaller (2-input) OR gates. Figure 4b shows the insertion of a stage of sampling elements **82** (referred as first-stage of sampling elements), splitting this tree into two pipe-line stages. Following this technique, in figure 3, a first-stage of sampling elements **82** is used to split the delay of the error detection circuit in two parts. The first part consists in the delay of one XOR gate **95** plus the delay of one OR gate **61** (OR1) receiving as inputs a subset of the error detection signals **E**. The second part consists in the delay of an OR gate **63** receiving as inputs the partial error detection signals **PE**. If necessary, that is, if the number of error detection signals **E** that have to be compressed into a global error detection signal **GE** is quite large and the use of a single stage of sampling elements is not sufficient for accommodating the delays of the error detection logic (the XOR gates and the OR tree), a larger number of sampling element stages can be inserted in the OR tree to accommodate these delays.

As illustrated in figure 3, the first and second sampling elements **92 93** are rated by the same clock signal **CK** but use different edges of this signal as latching events. To represent this case in figure 3 we use the following convention. If a circle is inserted on the clock terminal of a sampling element, the latching event of this element is the falling edge of the clock signal driving its clock terminal. In the other case, (i.e. no circle is inserted on the clock terminal of a sampling element), the latching event of this element is the rising edge of the clock signal driving its clock terminal. Thus, in figure 3, the latching event of first sampling element **92** is the rising edge of clock signal **CK**, while the latching event of second sampling element **93** is the falling edge of clock signal **CK**. In figure 3, the clock signals driving the first-stage of sampling elements **82** and the clock signal driving the terminal sampling element **84** are left unspecified. This is done in purpose, because the events that drive these sampling elements depend on the operating mode, as it is explained below.

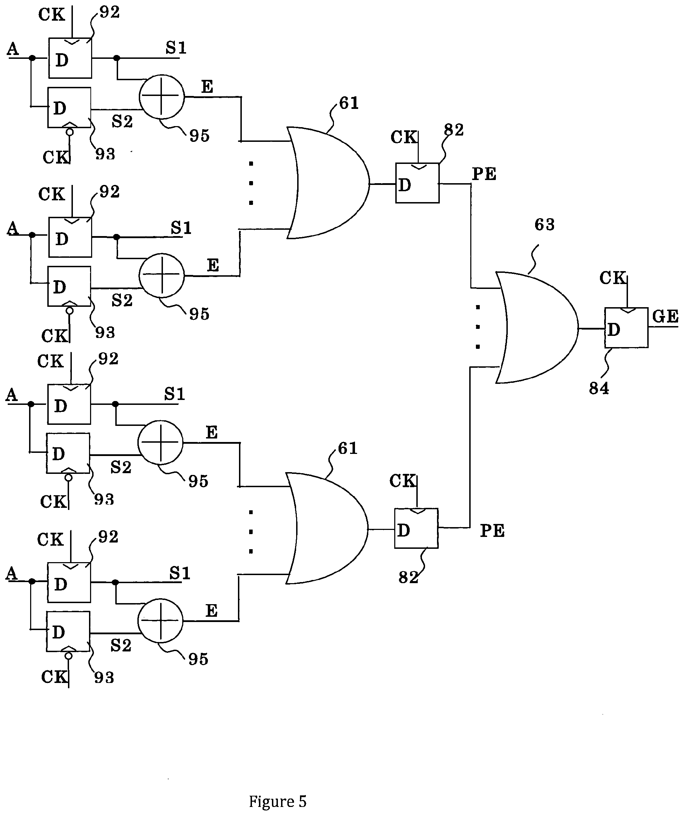

In the second operating mode (where the time interval Df separating the latching event of the first sampling elements **92** from the subsequent latching event of the second sampling element **93** is shorter than a shortest delay of the circuit), the comparator **95** should compare the value latched by the second sampling elements **93** at the latching event of this element occurring in clock cycle i, against the value latched by the first sampling elements **92** at the latching event of these elements occurring in clock cycle i. Then, to give time to the outputs of the second sampling elements to propagate through the XOR gate and the OR gate, the first-stage sampling elements **82** should latch their inputs after the latest of these latching events, (which is the latching event of the second sampling elements **93** in clock cycle i), and before the new values captured by the first sampling elements **92** at clock cycle i+1 have the time to reach the first-stage sampling elements **82**. A simple solution for enforcing these conditions is to use the latching event of the first sampling elements **93** as latching event of the first-stage sampling elements **82**. Then, the delay of the circuit comprised between the second sampling elements **93** and the first-stage sampling elements **82** should not exceed the time interval T- Df separating the latching event of the first sampling element of cycle i+1 from the latching event of the second sampling element of cycle i, that is D_{S2} + D_{XOR} + D_{OR1} + s₁ₛ < T- Df, where D_{S2} is the propagation delay of the second sampling element **92**, D_{XOR} is the delay of the XOR gate **95**, D_{OR1} is the delay of the OR gate **61** (OR1), and s₁ₛ is the setup time of a first-stage sampling element **82**. Also, we found earlier that the condition Df < D_{IN} + D_{SL} - h₂ should be verified in the second operating mode. Thus, to enforce the condition D_{S2} + D_{XOR} + D_{OR1} + s₁ₛ < T- Df we can set D_{IN} + D_{SL} - h₂ < T- (D_{S2} + D_{XOR} + D_{OR1} + s₁ₛ), from which we find D_{OR1} < T - D_{IN} - D_{S2} - D_{XOR} - s₁ₛ - D_{SL} + h₂. By replacing T by the minimum period Tₘ of the clock that can be employed in any application using the second operating mode, we find D_{OR1} < Tₘ - D_{IN} - D_{S2} - D_{XOR} - s₁ₛ - D_{SL} + h₂, which allows determining the positions in the OR tree in which we can insert the first-stage of sampling elements. Concerning the subsequent pipe-line stages, which could be used if we need to split the OR gate delay in many parts (in the case where the number of error detection signals **E** is very large), we have seen that subsequent sampling element stages **84** can use the same latching event as the first-stage sampling elements **82**. In this case, the time allocated to each of the subsequent pipe-line stages is equal to the clock period T. Thus, the delay of any subsequent pipe-line stages should not exceed T. Thus we find D_{Si-1} + D_{ORi} + sᵢ ≤ T, where D_{Si-1} is the propagation delay of a sampling element of stage i-1 of the error detection network, D_{ORi} is the delay of the OR gate used in the ith pipe-line stage of the error detection network (with i>), and sᵢ is the setup time of a sampling element of stage i of the error detection network. By considering, as above the minimum value Tₘ of T we find D_{ORi} > T_{L} - D_{Si-1} - sᵢ, which allows determining the positions in the OR gate tree in which we can insert the subsequent sampling element stages of the error detection network. Figure 5 shows the compression network implementation for the second operating mode, in the case where the latching event of the first sampling elements **92** is the rising edge of a clock signal **CK**, and the latching event of the second sampling elements **93** is the falling edge of this clock signal. Thus, following the implementation described above, the latching event of the first-stage sampling elements **82** will be the rising edge of the clock signal **CK**. This edge is also used as latching event for the subsequent stages of sampling elements **84**.

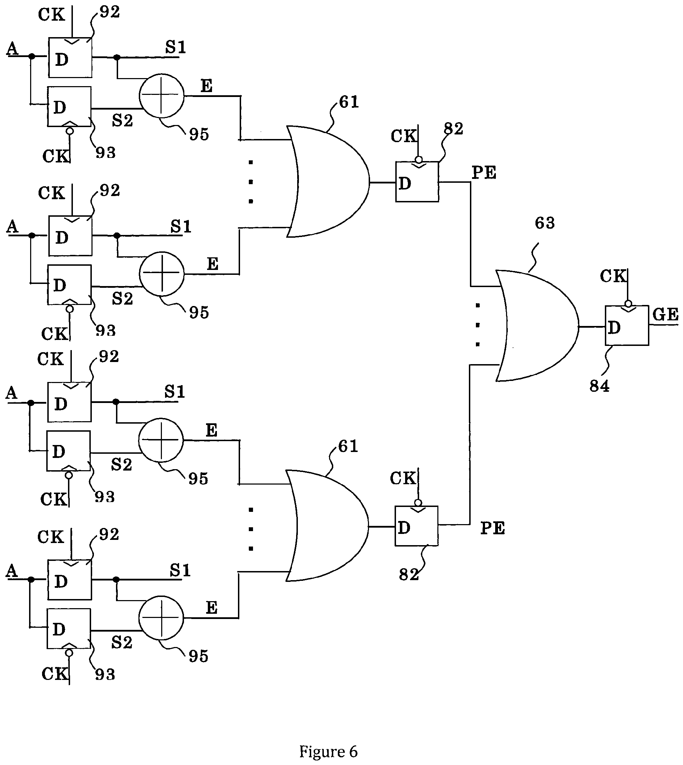

In the first operating mode (where the time interval Df separating the latching event of the first sampling elements **92** from the subsequent latching event of the second sampling element **93**, is larger than a largest delay of the circuit), the comparator **95** should compare the value latched by the second sampling elements **93** in clock cycle i, against the value latched by the first sampling elements **92** in clock cycle i+1. Then, the first-stage sampling elements **82** should latch their inputs some time after the latching event of first sampling elements in clock cycle i+1 (to give time to the outputs of the first sampling elements to propagate through the XOR gate and the OR gate), and before the new values captured by the second sampling element **93** at clock cycle i+1 have the time to reach the first-stage sampling elements **82**. A simple solution for enforcing this condition is to use the latching event of the second sampling elements **93** as latching event of the first-stage sampling elements **82**. In this implementation, the delay of the circuit comprised between the first sampling elements and the first-stage of sampling elements should not exceed the time interval Df separating the latching event of the first sampling element from the subsequent latching event of the second sampling element. That is D_{S1} + D_{XOR} + D_{OR1} + s₁ₛ < Df, where D_{S1} is the propagation delay of a first sampling element **92**, D_{XOR} is the propagation delay of the XOR gate **95**, D_{OR1} is the propagation delay of the OR gate **61** (OR1), and s₁ₛ is the setup time of a first-stage sampling element **82**. This gives D_{OR1} < Df - D_{S1} - D_{XOR} - s₁ₛ. By replacing the minimum value of Df in which the design will be used in the first operating mode we can determine the maximum value of D_{OR1} and thus the positions in the OR tree in which we can insert the first-stage of sampling elements. The minimum value of Df could be for instance D_{IN} + D_{LL} + s₂, since for the first operating mode we found earlier that Df > D_{IN} + D_{LL} + s₂, or some larger value. Concerning the subsequent pipe-line stages, we have seen that the subsequent sampling element stages **84** can use the same latching event as the first-stage sampling elements **82**. In this case, the time allocated to each of the subsequent pipe-line stages is equal to the clock period T. Thus, the positions in the OR gate tree in which we can insert the subsequent sampling element stages of the error detection network can be determined similarly to the second operating mode. Figure 6 shows the compression network implementation for the first operating mode, in the case where the latching event of the first sampling elements **92** is the rising edge of a clock signal **CK**, and the latching event of the second sampling elements **93** is the falling edge of this clock signal. Thus, following the implementation described above, the latching event of the first-stage sampling elements **82** will be the falling edge of the clock signal **CK**. This edge is also used as latching event for the subsequent stages of sampling elements **84**.

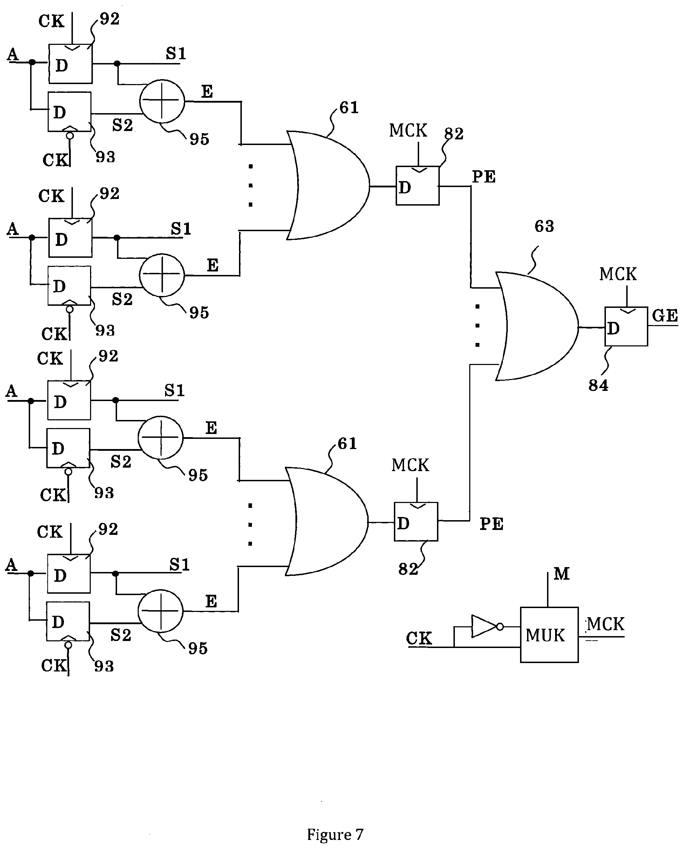

To design a circuit which can be used selectively in the first or in the second operating modes, we have to consider the fact that the latching events of the sampling elements used in the pipe-line stages of the error detection network are not the same in these modes. To cope with this issue, we use a signal M that selects the latching event corresponding to the current operating mode. This is shown in figure 7, for the case where the latching event of the first sampling elements is the rising edge of a clock signal **CK**, and the latching event of the second sampling elements is the falling edge of this clock signal. Then, as shown in the figure, signal **M** implements the operating mode in the network of the error detection signals. That is: **M** = 0 selects **MCK** = **CK** and implements the second operating mode, since in this case the latching event of the sampling elements of the error detection network is the rising edge of signal **CK**. **M** = 1 selects **MCK** = **CK!** and implements the first operating mode, since in this case the latching event of the sampling elements of the error detection network is the falling edge of signal **CK**. In addition we have to correctly design the pipe-lines of the error detection network. For doing so, we determine as discussed earlier the maximum value of D_{OR1} in each of these modes and we select the minimum of these two values, which determine the positions in the OR tree in which we can insert the first-stage sampling elements. We proceed similarly for the subsequent stages of sampling element. Thus, we can pipe-line the error detection network in a manner compatible with both operating modes. Note that, as we use the signal **MCK** to rate the sampling elements in the error detection network, we can add in the above delays the delay of the circuit generating **MCK** from **CK**.

## Claims

1. A circuit protected against timing errors and parasitic disturbances, the circuit comprising:
- a combinatory logic circuit (10) having at least one input and one output (A);
- an input sampling element (90) connected to said at least one input;
- a first sampling element (92) connected to said at least one output (A) and sampling this at least one output (A) at the activation of a first latching event determined by an event of a first edge of a clock signal (CK), the first sampling element (92) being separated from the input sampling element (90) by the combinatory logic circuit (10);
- a second sampling element (93) connected to said at least one output (A) and sampling this output at the activation of a second latching event, the second sampling element (93) being separated from the input sampling element (90) by the combinatory logic circuit (10) ;
- a circuit for analyzing (95) the outputs (S1, S2) of said first and said second sampling elements (92, 93) and providing an error detection signal (E), the analysis circuit (95) setting said error detection signal at said pre-determined value if the outputs of said first and said second sampling elements (S1, S2) are different;
**characterized in that** the second latching event is determined by an event of a second edge of said clock signal, **and in that** the circuit is used in at least a first operating mode in which the duty cycle and the period, called T, of said clock signal, are adapted so a time interval, called Df, between the second edge and the first edge preceding the second edge of said clock signal is larger than a delay corresponding to an addition of a propagation delay of the input sampling element (90), a largest delay of the combinatory logic circuit (10) and a setup time of the second sampling element (93).

2. The circuit according to claim 1, wherein during said first operating mode the duty cycle and the period of the clock signal are selected so that the interval T-Df exceeds the duration of detectable faults such as delay faults and clock skews.

3. The circuit according to claim 1, wherein during said first operating mode the duty cycle and the period of the clock signal are selected so that the interval T-Df exceeds the detectable margins between the clock period and the largest delay of the circuit.

4. The circuit according to any claim 1 to 3, wherein:
- the circuit comprises a plurality of pairs of said first and said second sampling elements (92, 93);
- the analyzing circuit comprising
∘ a plurality of two-input XOR gates (95), wherein each XOR gate receives on its inputs the outputs (S1, S2) of a pair of said first and said second sampling elements (92, 93),
∘ a tree of OR gates (61, 63) receiving as inputs the outputs (E) of said plurality of XOR gates and generating an output (GE) that takes the value 0 if all outputs (E) of said plurality of XOR gates (95) are 0 and the value 1 when one or more outputs (E) of said plurality of XOR gates (95) is 1.

5. The circuit according to claim 4, wherein, said tree of OR gates (61, 63) is pipelined by inserting at least a first stage of sampling elements (82) in selected positions of said tree of OR gates (61, 63), and wherein during said first operating mode the clock edge determining the latching event of said first stage of sampling elements (82) is the same as the clock edge determining the latching event of said second sampling elements (93).

6. The circuit according to claim 5, wherein said tree of OR gates (61, 63) is pipelined by inserting more than one stages of sampling elements (82) in selected positions of said tree of OR gates (61, 63), and wherein during said first operating mode the clock edge determining the latching event of said more than one stages of sampling elements (82) is the same as the clock edge determining the latching event of said second sampling elements (93).

7. The circuit according to any claim 1to 6, wherein the circuit is used in said first operating mode and in at least a second operating mode in response to environment, operational, or application constraints, by selectively adapting the duty cycle and the period of the clock signal so that the first edge of the clock signal precedes the second edge of the clock signal by a time interval that is shorter than the shortest delay of the circuit.

8. The circuit according to claim 7, wherein:
- the circuit comprises a plurality of pairs of said first and said second sampling elements (92, 93);
- the analyzing circuit comprising
∘ a plurality of two-input XOR gates, wherein each XOR gate (95) receives on its inputs the outputs (S1, S2) of a pair of said first and said second sampling elements (92, 93),
∘ a tree of OR gates (61, 63) receiving as inputs the outputs of said plurality of XOR gates and generating an output (E) that takes the value 0 if all outputs of said plurality of XOR gates (95) are 0 and the value 1 when one or more outputs (E) of said plurality of XOR gates (95) is 1.

9. The circuit according to claim 8, wherein, said tree of OR gates (61, 63) is pipelined by inserting at least a first stage of sampling elements (82) in selected positions of said tree of OR gates (61, 63), and wherein during said second operating mode the clock edge determining the latching event of said first stage of sampling elements (82) is the same as the clock edge determining the latching event of said first sampling elements (93).

10. The circuit according to of claim 9, wherein said tree of OR gates (61, 63) is pipelined by inserting more than one stages of sampling elements (82) in selected positions of said tree of OR gates (61, 63), and wherein during said second operating mode the clock edge determining the latching event of said more than one stages of sampling elements (82) is the same as the clock edge determining the latching event of said first sampling elements (93).

## Patentansprüche

1. Schaltung, die gegen Timing-Fehler und parasitäre Störungen geschützt ist, wobei die Schaltung umfasst:
- eine Kombinatoriklogik-Stufe (10), die zumindest einen Eingang und einen Ausgang (A) besitzt;
- ein Eingangsabtast-Element (90), das mit dem zumindest einen Eingang verbunden ist;
- ein erstes Abtastelement (92), das mit dem zumindest einen Ausgang (A) verbunden ist, wobei es diesen zumindest einen Ausgang (A) dann, wenn ein erster Verriegelungs-Vorgang aktiviert wird, abtastet, der von einem Erscheinen einer ersten Flanke eines Taktsignals (CK) bestimmt wird, wobei das erste Abtastelement (92) vom Eingangsabtast-Element (90) durch die Kombinatoriklogik-Stufe (10) getrennt ist;
- ein zweites Abtastelement (93), das mit dem zumindest einen Ausgang (A) verbunden ist und diesen Ausgang dann abtastet, wenn ein zweiter Verriegelungs-Vorgang aktiviert wird, wobei das zweite Abtast-Element (93) vom Eingangsabtast-Element (90) durch die Kombinatoriklogik-Stufe (10) getrennt ist;
- eine Stufe (95), um die Ausgänge (S1, S2) des ersten und des zweiten Abtast-Elements (92, 93) zu analysieren und ein Fehlerdetektions-Signal (E) zu liefern, wobei die Analyse-Stufe (95) das Fehlerdetektions-Signal dann auf einen vorgegebenen Wert setzt, wenn die Ausgänge des ersten und des zweiten Abtast-Elements (S1, S2) verschieden sind;
**dadurch gekennzeichnet, dass** der zweite Verriegelungs-Vorgang von einem Auftreten einer zweiten Flanke des Taktsignals bestimmt wird, und dass die Schaltung in zumindest einer ersten Betriebsart betrieben wird, in der das Tastverhältnis und das Intervall, das mit T bezeichnet wird, des Taktsignals, so ausgelegt sind, dass ein Zeitintervall, das mit Df bezeichnet wird, zwischen der zweiten Flanke und der ersten Flanke des Taktsignals, die der zweiten Flanke vorauseilt, größer als eine Verzögerung ist, die einer Addition einer Laufzeitverzögerung des Eingangsabtast-Elements (90), einer größten Verzögerung der Kombinatoriklogik-Stufe (10) und einer Einstellzeit des zweiten Abtast-Elements (93) entspricht.

2. Schaltung gemäß Anspruch 1, wobei in der ersten Betriebsart das Tastverhältnis und das Intervall des Taktsignals so gewählt werden, dass das Intervall T-Df größer als die Dauer der detektierbaren Fehler ist, wie etwa Verzögerungs-Fehler und Taktschwankungen.

3. Schaltung gemäß Anspruch 1, wobei in der ersten Betriebsart das Tastverhältnis und das Intervall des Taktsignals so gewählt werden, dass das Intervall T-Df größer als die detektierbaren Grenzen zwischen dem Taktintervall und der größten Verzögerung der Schaltung ist.

4. Schaltung gemäß irgendeinem der Ansprüche 1 bis 3, wobei:
- die Schaltung eine Vielzahl von Paaren aus dem ersten und dem zweiten Abtast-Element (92, 93) umfasst;
- die Analyse-Stufe umfasst:
∘ eine Vielzahl von exklusiv-ODER Gattern mit zwei Eingängen (95), wobei jedes exklusiv-ODER Gatter an seinen Eingängen die Ausgänge (S1, S2) von einem Paar des ersten und des zweiten Abtast-Elements (92, 93) empfängt,
∘ einen Baum aus ODER-Gattern (61, 63), die als Eingänge die Ausgänge (E) der Vielzahl von exklusiv-ODER Gattern empfangen und einen Ausgang (GE) generieren, der dann den Wert 0 annimmt, wenn alle Ausgänge (E) der Vielzahl von exklusiv-ODER Gattern (95) gleich 0 sind, und dann den Wert 1 annimmt, wenn ein Ausgang oder mehrere Ausgänge (E) der Vielzahl von exklusiv-ODER Gattern (95) gleich 1 sind.

5. Schaltung gemäß Anspruch 4, wobei in den Strompfad des Baums aus den ODER-Gattern (61, 63) an ausgewählten Positionen des Baums aus den ODER-Gattern (61, 63) zumindest eine erste Stufe von Abtast-Elementen (82) eingesetzt ist, und wobei in der ersten Betriebsart die Taktflanke, die den Verriegelungs-Vorgang der ersten Stufe von Abtast-Elementen (82) bestimmt, dieselbe Taktflanke wie jene Taktflanke ist, die den Verriegelungs-Vorgang der zweiten Abtast-Elemente (93) bestimmt.

6. Schaltung gemäß Anspruch 5, wobei im Strompfad des Baums aus den ODER-Gattern (61, 63) an ausgewählten Positionen des Baums aus den ODER-Gattern (61, 63) mehr als eine Stufe von Abtast-Elementen (82) eingesetzt ist, und wobei in der ersten Betriebsart die Taktflanke, die den Verriegelungs-Vorgang der mehr als einen Stufe von Abtast-Elementen (82) bestimmt, dieselbe Taktflanke wie jene Taktflanke ist, die den Verriegelungs-Vorgang der zweiten Abtast-Elemente (93) bestimmt.

7. Schaltung gemäß irgendeinem der Ansprüche 1 bis 6, wobei die Schaltung in der ersten Betriebsart sowie in zumindest einer zweiten Betriebsart in Abhängigkeit von Umwelt-, Betriebs- oder Anwendungs-Bedingungen betrieben wird, indem das Tastverhältnis und das Intervall des Taktsignals selektiv so angepasst werden, dass die erste Flanke des Taktsignals der zweiten Flanke des Taktsignals um ein Zeitintervall vorauseilt, das kürzer als die kürzeste Verzögerung der Schaltung ist.

8. Schaltung gemäß Anspruch 7, wobei:
- die Schaltung eine Vielzahl von Paaren des ersten und des zweiten Abtast-Elements (92, 93) umfasst;
- die Analyse-Stufe umfasst:
∘ eine Vielzahl von exklusiv-ODER Gattern mit zwei Eingängen, wobei jedes exklusiv-ODER Gatter (95) an seinen Eingängen die Ausgänge (S1, S2) eines Paars aus dem ersten und dem zweiten Abtast-Element (92, 93) empfängt,
∘ einen Baum aus ODER-Gattern (61, 63), die als Eingänge die Ausgänge der Vielzahl von exklusiv-ODER Gattern empfangen und einen Ausgang (E) generieren, der dann den Wert 0 annimmt, wenn alle Ausgänge der Vielzahl von exklusiv-ODER Gattern (95) gleich 0 sind, und dann den Wert 1 annimmt, wenn ein Ausgang oder mehrere Ausgänge (E) der Vielzahl von exklusiv-ODER Gattern (95) gleich 1 ist.

9. Schaltung gemäß Anspruch 8, wobei im Strompfad des Baums aus den ODER-Gattern (61, 63) an ausgewählten Positionen des Baums aus den ODER-Gattern (61, 63) zumindest eine erste Stufe von Abtast-Elementen (82) eingesetzt ist, und wobei in der zweiten Betriebsart die Taktflanke, die den Verriegelungs-Vorgang der ersten Stufe von Abtast-Elementen (82) bestimmt, dieselbe Taktflanke wie jene Taktflanke ist, die den Verriegelungs-Vorgang der ersten Abtast-Elemente (93) bestimmt.

10. Schaltung gemäß Anspruch 9, wobei im Strompfad des Baums aus den ODER-Gattern (61, 63) an ausgewählten Positionen des Baums aus den ODER-Gattern (61, 63) mehr als eine Stufe von Abtast-Elementen (82) eingesetzt ist, und wobei in der zweiten Betriebsart die Taktflanke, die den Verriegelungs-Vorgang der mehr als einen Stufe von Abtast-Elementen (82) bestimmt, dieselbe Taktflanke wie jene Taktflanke ist, die den Verriegelungs-Vorgang der ersten Abtast-Elemente (93) bestimmt.

## Revendications

1. Circuit protégé contre les erreurs de synchronisation et les perturbations parasites, le circuit comprenant :
- un circuit logique combinatoire (10) comportant au moins une entrée et une sortie (A) ;
- un élément d'échantillonnage d'entrée (90) relié à ladite au moins une entrée ;
- un premier élément d'échantillonnage (92) relié à ladite au moins une sortie (A) et échantillonnant cette au moins une sortie (A) lors de l'activation d'un premier événement de verrouillage déterminé par un événement d'un premier front d'un signal d'horloge (CK), le premier élément d'échantillonnage (92) étant séparé de l'élément d'échantillonnage d'entrée (90) par le circuit logique combinatoire (10) ;
- un deuxième élément d'échantillonnage (93) relié à ladite au moins une sortie (A) et échantillonnant cette sortie lors de l'activation d'un deuxième événement de verrouillage, le deuxième élément d'échantillonnage (93) étant séparé de l'élément d'échantillonnage d'entrée (90) par le circuit logique combinatoire (10) ;
- un circuit (95) d'analyse des sorties (S1, S2) desdits premier et deuxième éléments d'échantillonnage (92, 93) et de production d'un signal de détection d'erreur (E), le circuit d'analyse (95) fixant ledit signal de détection d'erreur à ladite valeur prédéterminée si les sorties desdits premier et deuxième éléments d'échantillonnage (S1, S2) sont différentes ;
**caractérisé en ce que** le deuxième événement de verrouillage est déterminé par un événement d'un deuxième front dudit signal d'horloge, et **en ce que** le circuit est utilisé dans au moins un premier mode de fonctionnement dans lequel le rapport cyclique et la période, appelée T, dudit signal d'horloge, sont adaptés pour qu'un intervalle de temps, appelé Df, entre le deuxième front et le premier front précédant le deuxième front dudit signal d'horloge soit supérieur à un retard correspondant à l'addition d'un retard de propagation de l'élément d'échantillonnage d'entrée (90), d'un plus grand retard du circuit logique combinatoire (10) et d'un temps d'initialisation du deuxième élément d'échantillonnage (93).

2. Circuit selon la revendication 1, dans lequel, pendant ledit premier mode de fonctionnement, le rapport cyclique et la période du signal d'horloge sont sélectionnés de sorte que l'intervalle T-Df dépasse la durée des défauts détectables tels que les défauts de retard et les décalages d'horloge.

3. Circuit selon la revendication 1, dans lequel, pendant ledit premier mode de fonctionnement, le rapport cyclique et la période du signal d'horloge sont sélectionnés de sorte que l'intervalle T-Df dépasse les marges détectables entre la période d'horloge et le plus grand retard du circuit.

4. Circuit selon l'une quelconque des revendications 1 à 3 dans lequel :
- le circuit comprend une pluralité de paires des dits premier et deuxième éléments d'échantillonnage (92, 93) ;
- le circuit d'analyse comprenant
∘ une pluralité de portes OU exclusif à deux entrées (95), dans lesquelles chaque porte OU exclusif reçoit sur ses entrées les sorties (S1, S2) d'une paire des dits premier et deuxième éléments d'échantillonnage (92, 93),
∘ une arborescence de portes OU (61, 63) recevant comme entrées les sorties (E) de ladite pluralité de portes OU exclusif et générant une sortie (GE) prenant la valeur 0 si toutes les sorties (E) de ladite pluralité de portes OU exclusif (95) sont 0 et la valeur 1 si au moins une sortie (E) de ladite pluralité de portes OU exclusif (95) est 1.

5. Circuit selon la revendication 4, dans lequel ladite arborescence de portes OU (61, 63) est mise en pipeline par insertion d'au moins un premier étage d'éléments d'échantillonnage (82) dans des positions sélectionnées de ladite arborescence de portes OU (61, 63) et dans lequel, pendant ledit premier mode de fonctionnement, le front d'horloge qui détermine l'événement de verrouillage dudit premier étage d'éléments d'échantillonnage (82) étant identique au front d'horloge qui détermine l'événement de verrouillage desdits deuxièmes éléments d'échantillonnage (93) .

6. Circuit selon la revendication 5, dans lequel ladite arborescence de portes OU (61, 63) est mise en pipeline par insertion de plus d'un étage d'éléments d'échantillonnage (82) dans des positions sélectionnées de ladite arborescence de portes OU (61, 63) et dans lequel, pendant ledit premier mode de fonctionnement, le front d'horloge qui détermine l'événement de verrouillage de plus d'un étage d'éléments d'échantillonnage (82) est identique au front d'horloge qui détermine l'événement de verrouillage desdits deuxièmes éléments d'échantillonnage (93).

7. Circuit selon l'une quelconque des revendications 1 à 6, dans lequel le circuit est utilisé dans ledit premier mode de fonctionnement et dans au moins un deuxième mode de fonctionnement en réponse à des contraintes d'environnement, de fonctionnement ou d'application, par adaptation sélective du rapport cyclique et de la période du signal d'horloge de sorte que le premier front du signal d'horloge précède le deuxième front du signal d'horloge d'un intervalle de temps plus court que le retard le plus court du circuit.

8. Circuit selon la revendication 7 dans lequel :
- le circuit comprend une pluralité de paires des dits premier et deuxième éléments d'échantillonnage (92, 93) ;
- le circuit d'analyse comprenant
∘ une pluralité de portes OU exclusif à deux entrées, chaque porte OU exclusif (95) reçoit sur ses entrées les sorties (S1, S2) d'une paire des dits premier et deuxième éléments d'échantillonnage (92, 93),
∘ une arborescence de portes OU (61, 63) recevant comme entrées les sorties de ladite pluralité de portes OU exclusif et générant une sortie (E) prenant la valeur 0 si toutes les sorties de ladite pluralité de portes OU exclusif (95) sont 0 et la valeur 1 si au moins une sortie (E) de ladite pluralité de portes OU exclusif (95) est 1.

9. Circuit selon la revendication 8 dans lequel, ladite arborescence de portes OU (61, 63) est mise en pipeline par insertion d'au moins un premier étage d'éléments d'échantillonnage (82) dans des positions sélectionnées de ladite arborescence de portes OU (61, 63) et dans lequel, pendant ledit deuxième mode de fonctionnement, le front d'horloge qui détermine l'événement de verrouillage dudit premier étage d'éléments d'échantillonnage (82) est identique au front d'horloge qui détermine l'événement de verrouillage desdits premiers éléments d'échantillonnage (93).

10. Circuit selon la revendication 9 dans lequel, ladite arborescence de portes OU (61, 63) est mise en pipeline par insertion de plus d'un étage d'éléments d'échantillonnage (82) dans des positions sélectionnées de ladite arborescence de portes OU (61, 63) et dans lequel, pendant ledit deuxième mode de fonctionnement, le front d'horloge qui détermine l'événement de verrouillage de plusieurs étages d'éléments d'échantillonnage (82) est identique au front d'horloge qui détermine l'événement de verrouillage desdits premiers éléments d'échantillonnage (93).
